# EUROPÄISCHE PATENTANMELDUNG

(11) **EP 2 584 705 A1**
(43) Veröffentlichungstag der Anmeldung: **24.04.2013**
(21) Anmeldenummer: 12184346.0
(22) Anmeldetag: 14.09.2012
(51) Int. Cl.: H03K 17/96

(54) **Sensorsockel für einen Infrarotsensor eines Tastschalters und Steuergerät mit dem Sensorsockel**

(30) Priorität: 17.10.2011 DE 102011084615
(71) Anmelder: ZF Friedrichshafen AG, 88038 Friedrichshafen (DE)
(72) Erfinder: Hundenkov, Danil, 95444 Bayreuth (DE); Szabo, Tomas, 35601 Sokolov (CZ); O'Bryant, Ronald, 95444 Bayreuth (DE)

(57) **Zusammenfassung**

Es wird ein Sensorsockel (110) für einen Infrarotsensor (102) eines Tastschalters vorgeschlagen. Der Sensorsockel (110) weist einen Senderabschnitt sowie einen Empfängerabschnitt und eine Lichtleiteinrichtung auf, welche wiederum ein Verbindungselement (118) und einen einstückig mit dem Verbindungselement (118) gebildeten, ersten Lichtleiter (114) sowie einen einstückig mit dem Verbindungselement (118) gebildeten, zweiten Lichtleiter (116) aufweist. Dabei ist der erste Lichtleiter (114) in dem Senderabschnitt angeordnet und ist der zweite Lichtleiter (116) in dem Empfängerabschnitt angeordnet. Der erste Lichtleiter (114) und der zweite Lichtleiter (116) erstrecken sich von einer ersten Hauptoberfläche des Verbindungselements (118) in eine gemeinsame Richtung weg.

## Beschreibung

Die vorliegende Erfindung bezieht sich auf einen Sensorsockel für einen Infrarotsensor eines Tastschalters und auf ein Steuergerät, insbesondere für ein Haushaltsgerät mit einem zumindest teilweise lichtdurchlässigen Bedienfeld, mit dem Sensorsockel.

Ein berührungsempfindlicher Tastschalter weist beispielsweise einen Infrarotsensor auf, der einen Sensorsockel umfassen kann, der aus infrarotlichtdichtem Material besteht. In dem Sockel befindet sich beispielsweise ein so genannter Lichtleiter, welcher das von einem Sender ausgehende Licht wegleitet und wieder in einen Empfänger zurückleitet. Bei einem solchen Lichtleiter werden für gewöhnlich zwei zylindrische Lichtleiter für den Sender und den Empfänger verwendet. Bei den bisher verwendeten Lichtleitern handelt es sich um herkömmliche Lichtleiter. Der von dem Sender ausgegebene infrarote Lichtstrahl wird durch den Lichtleiter geleitet, von einem Betätiger reflektiert und an den Empfänger geleitet. Dabei wird der Lichtstrahl üblicherweise punktuell abgestrahlt und auch wiederum punktuell empfangen.

Die DE 10 2004 025 878 B4 bezieht sich auf einen berührungsempfindlichen Tastschalter.

Vor diesem Hintergrund schafft die vorliegende Erfindung einen verbesserten Sensorsockel für einen Infrarotsensor eines Tastschalters und ein verbessertes Steuergerät, insbesondere für ein Haushaltsgerät mit einem zumindest teilweise lichtdurchlässigen Bedienfeld, mit dem Sensorsockel, gemäß den Hauptansprüchen. Vorteilhafte Ausgestaltungen ergeben sich aus den Unteransprüchen und der nachfolgenden Beschreibung.

Die vorliegende Erfindung schafft einen Sensorsockel für einen Infrarotsensor eines Tastschalters, wobei der Sensorsockel einen Senderabschnitt sowie einen Empfängerabschnitt und eine Lichtleiteinrichtung aufweist, dadurch gekennzeichnet, dass die Lichtleiteinrichtung ein Verbindungselement und einen einstückig mit dem Verbindungselement gebildeten, ersten Lichtleiter sowie einen einstückig mit dem Verbindungselement gebildeten, zweiten Lichtleiter aufweist, wobei der erste Lichtleiter in dem Senderabschnitt angeordnet ist und der zweite Lichtleiter in dem Empfängerabschnitt angeordnet ist, wobei sich der erste Lichtleiter und der zweite Lichtleiter von einer ersten Hauptoberfläche des Verbindungselements in eine gemeinsame Richtung weg erstrecken.

Der oben genannte Sensorsockel kann in Verbindung mit einem Haushaltsgerät, insbesondere einem Kochfeld oder dergleichen, verwendet bzw. eingesetzt werden. Somit kann der Tastschalter, der den Infrarotsensor aufweist, welcher den Sensorsockel umfasst, zur Verwendung in Verbindung mit dem Haushaltsgerät vorgesehen sein. Der Sensorsockel kann aus einem für Infrarotlicht bzw. elektromagnetische Strahlung im Infrarotbereich undurchlässigen Material hergestellt sein. Der Sensorsockel kann dabei einen Sockelkörper mit dem Senderabschnitt und dem Empfängerabschnitt aufweisen. Der Senderabschnitt kann benachbart zu einem Sender für elektromagnetische Strahlung im Infrarotbereich des Infrarotsensors angeordnet werden. Der Senderabschnitt kann ausgebildet sein, um den ersten Lichtleiter aufzunehmen. Der Senderabschnitt kann auch ausgebildet sein, um den ersten Lichtleiter und einen ersten Abschnitt des Verbindungselements aufzunehmen. Somit kann es sich bei dem ersten Lichtleiter um einen Sendelichtleiter handeln. Der Empfängerabschnitt kann benachbart zu einem Empfänger für elektromagnetische Strahlung im Infrarotbereich des Infrarotsensors angeordnet werden. Der Empfängerabschnitt kann ausgebildet sein, um den zweiten Lichtleiter aufzunehmen. Der Empfängerabschnitt kann auch ausgebildet sein, um den zweiten Lichtleiter und einen zweiten Abschnitt des Verbindungselements aufzunehmen. Somit kann es sich bei dem zweiten Lichtleiter um einen Empfangslichtleiter handeln. Die Lichtleiteinrichtung kann somit als eine einstückige Einheit aus dem Verbindungselement und dem ersten Lichtleiter sowie dem zweiten Lichtleiter gebildet sein. Bei dem Verbindungselement kann es sich um ein optisches Element handeln. Das Verbindungselement kann zumindest teilweise lichtdurchlässig ausgebildet sein. Das Verbindungselement kann eine Brücke, Halterung oder dergleichen für den ersten Lichtleiter und den zweiten Lichtleiter repräsentieren. Infrarotlicht von einem Sender des Infrarotsensors kann an einem von dem Verbindungselement abgewandten Ende des ersten Lichtleiters eingekoppelt werden, sich entlang dem ersten Lichtleiter ausbreiten, an der ersten Hauptoberfläche des Verbindungselements in dasselbe eintreten und an einer von der ersten Hauptoberfläche abgewandten, zweiten Hauptoberfläche des Verbindungselements aus der Lichtleiteinrichtung ausgekoppelt werden. Von einem zu erfassenden Objekt reflektiertes Infrarotlicht kann an der zweiten Hauptoberfläche des Verbindungselements wieder in die Lichtleiteinrichtung eingekoppelt werden, an der ersten Hauptoberfläche des Verbindungselements in den zweiten Lichtleiter eintreten, sich entlang dem zweiten Lichtleiter ausbreiten und an einem von dem Verbindungselement abgewandten Ende des zweiten Lichtleiters zu einem Empfänger des Infrarotsensors ausgekoppelt werden.

Die vorliegende Erfindung schafft ferner ein Steuergerät, insbesondere für ein Haushaltsgerät mit einem zumindest teilweise lichtdurchlässigen Bedienfeld, wobei das Steuergerät einen berührungsempfindlichen Tastschalter mit einem Infrarotsensor aufweist, dadurch gekennzeichnet, dass der Infrarotsensor einen Sensorsockel gemäß einem der vorangegangenen Ansprüche aufweist, wobei das Verbindungselement der Lichtleiteinrichtung des Sensorsockels benachbart zu dem Bedienfeld des Haushaltsgeräts anordenbar ist.

In Verbindung mit dem obigen Steuergerät kann ein oben genannter Sensorsockel gemäß Ausführungsformen der vorliegenden Erfindung vorteilhaft verwendet bzw. eingesetzt werden. Bei dem Haushaltsgerät kann es sich um ein Kochfeld oder dergleichen handeln. Ein solches Kochfeld kann eine Glasplatte bzw. Glaskeramikplatte mit einer Noppenstruktur aufweisen. Die Noppenstruktur kann an einer Unterseite der Glasplatte angeordnet sein, wobei die Unterseite von einer Kochoberfläche der Glasplatte abgewandt ist. Ein Abschnitt der Glasplatte eines solchen Kochfeldes kann das zumindest teilweise lichtdurchlässige Bedienfeld umfassen. Hierbei kann genau gesagt eine von der ersten Hauptoberfläche abgewandte, zweite Hauptoberfläche des Verbindungselements des Sensorsockels benachbart zu der Unterseite der Glasplatte in dem Bereich des Bedienfelds angeordnet sein.

Der vorliegenden Erfindung liegt die Erkenntnis zugrunde, dass eine Lichtleiteinrichtung eines Sensorsockels für einen Infrarotsensor eines Tastschalters einstückig ausgebildet sein kann und Infrarotlicht innerhalb der Lichtleiteinrichtung bzw. eines Verbindungselements der Lichtleiteinrichtung zwischen einem Sendelichtleiter und einem Empfangslichtleiter der Lichtleiteinrichtung gut geführt und beispielsweise durch einen Trennsteg sehr effizient optisch getrennt werden kann.

Ein Vorteil der vorliegenden Erfindung besteht darin, dass ein solcher Sensorsockel aufgrund der einstückigen Ausführung der Lichtleiteinrichtung einen einfachen Aufbau aufweist und somit kostengünstig und Platz sparend hergestellt werden kann. Zudem ist eine Ausrichtung der einzelnen Lichtleiter aufgrund des Verbindungselements vereinfacht sowie stabil. Zudem kann mittels des Trennstegs ein Überspringen von Störlicht innerhalb der Lichtleiteinrichtung von dem ersten Lichtleiter zu dem zweiten Lichtleiter vorteilhaft verhindert werden. Somit können durch den Sensorsockel eine Genauigkeit und Sicherheit des Infrarotsensors bzw. des Tastschalters verbessert werden.

Gemäß einer Ausführungsform kann das Verbindungselement der Lichtleiteinrichtung einen Lichtstreuungsabschnitt aufweisen, der zumindest im Bereich des Senderabschnitts des Sensorsockels an einer von der ersten Hauptoberfläche abgewandten, zweiten Hauptoberfläche des Verbindungselements angeordnet ist. Die zweite Hauptoberfläche kann im Bereich des Senderabschnitts eine Austrittsoberfläche für Infrarotlicht repräsentieren. Im Bereich des Empfängerabschnitts kann die zweite Hauptoberfläche eine Eintrittsoberfläche für Infrarotlicht repräsentieren. Der Lichtstreuungsabschnitt ist somit an der Austrittsoberfläche des Verbindungselements angeordnet. Der Lichtstreuungsabschnitt ist ausgebildet, um die von dem Sender abgestrahlte elektromagnetische Strahlung im Infrarotbereich einer diffusen Streuung zu unterziehen. Eine solche Ausführungsform der vorliegenden Erfindung bietet den Vorteil, dass austretendes Infrarotlicht mittels des Lichtstreuungsabschnitts möglichst homogen verteilt werden kann und sich somit Störeinflüsse durch Veränderungen eines zu erfassenden Objekts und/oder von Objekten zwischen dem Sensorsockel und dem zu erfassenden Objekt reduzieren oder beseitigen lassen.

Dabei kann der Lichtstreuungsabschnitt einen strukturierten Abschnitt der zweiten Hauptoberfläche des Verbindungselements aufweisen. Der strukturierte Abschnitt kann eine profilierte bzw. erodierte Struktur aufweisen. Der strukturierte Abschnitt kann eine definierte Struktur aufweisen. Beispielsweise kann der strukturierte Abschnitt aufgeraut, gerillt oder dergleichen ausgebildet sein. Der strukturierte Abschnitt kann auch ausgebildet sein, um wie eine Zerstreuungslinse zu wirken. Der strukturierte Abschnitt kann bei einer Herstellung der Lichtleiteinrichtung beispielsweise mittels Spritzgießens oder bei oder nach der Herstellung mittels einer Lasertechnik gebildet werden. Eine solche Ausführungsform der vorliegenden Erfindung bietet den Vorteil, dass hierbei eine verbesserte und genau definierte Streuwirkung für das Infrarotlicht auf einfache Weise erhalten werden kann.

Auch kann sich der strukturierte Abschnitt von der zweiten Hauptoberfläche zumindest teilweise in das Verbindungselement der Lichtleiteinrichtung erstrecken. Dabei kann der strukturierte Abschnitt mittels einer Lasertechnik hergestellt werden. Eine solche Ausführungsform der vorliegenden Erfindung bietet den Vorteil, dass die Streuwirkung für das Infrarotlicht weiter verbessert werden kann.

Ferner kann der Lichtstreuungsabschnitt einen Abschnitt aufweisen, der bezüglich eines weiteren Abschnitts zweiten Hauptoberfläche des Verbindungselements geneigt ist. Eine solche Neigung kann ausgebildet sein, um eine Streuung des Infrarotlichts zu bewirken. Eine solche Ausführungsform der vorliegenden Erfindung bietet den Vorteil, dass auf diese Weise eine vorteilhafte Streuwirkung für das Infrarotlicht auf besonders unkomplizierte Weise erhalten werden kann.

Auch kann der Lichtstreuungsabschnitt eine an der zweiten Hauptoberfläche des Verbindungselements aufgebrachte, strukturierte Schicht aufweisen. Bei der strukturierten Schicht kann es sich um eine Folie oder dergleichen handeln, in der eine Lichtstreuungsstruktur gebildet ist. Die strukturierte Schicht kann beispielsweise mittels eines geeigneten Fügeverfahrens auf zumindest einen Teil der zweiten Hauptoberfläche des Verbindungselements aufgebracht werden. Eine solche Ausführungsform der vorliegenden Erfindung bietet den Vorteil, dass eine Anwendungsflexibilität des Sensorsockels erhöht wird, da eine an die beabsichtigte Anwendung spezifisch angepasste, strukturierte Schicht zur Lichtstreuung eingesetzt werden kann. Somit kann eine Standard-Lichtleiteinrichtung mittels der strukturierten Schicht anwendungsspezifisch gemacht werden, was Kosten sowie Komplexität senken kann.

Zudem kann das Verbindungselement der Lichtleiteinrichtung einen weiteren Lichtstreuungsabschnitt aufweisen, der zumindest im Bereich des Empfängerabschnitts des Sensorsockels an der zweiten Hauptoberfläche des Verbindungselements angeordnet ist. Der weitere Lichtstreuungsabschnitt kann somit an der Eintrittsoberfläche des Verbindungselements angeordnet sein. Auch kann der weitere Lichtstreuungsabschnitt mit dem Lichtstreuungsabschnitt in dem Senderabschnitt gemeinsam oder durchgehend ausgebildet sein. Dabei können der Lichtstreuungsabschnitt und der weitere Lichtstreuungsabschnitt ausgebildet sein, um die Streuwirkung für das Infrarotlicht auf gleiche oder unterschiedliche Weise gemäß den obigen Ausführungsformen zu bewirken. Beispielsweise kann eine durchgehende strukturierte Schicht an der zweiten Hauptoberfläche des Verbindungselements aufgebracht sein, wobei sich die Schicht über den Senderabschnitt sowie den Empfängerabschnitt erstrecken kann. Eine solche Ausführungsform der vorliegenden Erfindung bietet den Vorteil, dass durch die Streuwirkung für das Infrarotlicht auf Empfängerseite somit eine Verteilung über eine möglichst homogene Fläche, und damit eine Verringerung möglicher Störeinflüsse, erreicht wird, was eine Genauigkeit und Sicherheit einer Erfassung durch den Infrarotsensor erhöht.

Gemäß einer besonders vorteilhaften Ausführungsform der vorliegenden Erfindung kann der Sensorsockel einen Trennsteg zwischen dem Senderabschnitt und dem Empfängerabschnitt aufweisen, der ausgebildet ist, um eine optische Trennung der Lichtleiteinrichtung zwischen dem Senderabschnitt und dem Empfängerabschnitt zu bewirken. Der Trennsteg ist beispielsweise ausgebildet, um eine Ausbreitung des Infrarotlichts innerhalb des Verbindungselements von dem Senderabschnitt zu dem Empfängerabschnitt des Sensorsockels zu verhindern.

Gemäß einer Ausführungsform kann sich der Trennsteg zumindest teilweise bis zu einer von der ersten Hauptoberfläche abgewandten, zweiten Hauptoberfläche des Verbindungselements der Lichtleiteinrichtung erstrecken. Der Trennsteg ist dabei ausgebildet, um das Verbindungselement zwischen dem Senderabschnitt und dem Empfängerabschnitt optisch, d.h. licht undurchlässig zu trennen. Unter einer optischen Trennung wird in dieser Offenbarung auch eine Trennung verstanden, die undurchlässig für Licht im infraroten Spektralbereich ist. Eine solche Ausführungsform der vorliegenden Erfindung bietet den Vorteil, dass wirksam verhindert werden kann, dass ausgesendetes Infrarotlicht innerhalb der Lichtleiteinrichtung zu dem Empfangslichtleiter überspringen kann. Somit können durch ein solches Überspringen bedingte Erfassungsfehler des Infrarotsensors auf einfache Weise vermieden werden.

Dabei kann das Verbindungselement eine Ausnehmung oder Öffnung für den Trennsteg aufweisen, die sich von der ersten Hauptoberfläche zumindest teilweise bis zu der zweiten Hauptoberfläche erstreckt. Die Ausnehmung oder Öffnung kann hierbei geeignet dimensioniert sein, so dass im zusammengefügten Zustand des Sensorsockels der Trennsteg möglichst passgenau in die Ausnehmung oder Öffnung eingreifen oder durchgreifen kann. Eine solche Ausführungsform der vorliegenden Erfindung bietet den Vorteil, dass eine optimale Passung der Lichtleiteinrichtung bezüglich eines Körpers des Sensorsockels erreicht werden kann, wobei der Trennsteg in das Verbindungselement hineinragen kann, was die optische Trennwirkung des Trennstegs verbessert. Zugleich kann eine zuverlässige und stabile Verbindung durch den in die Lichtleiteinrichtung eingepassten Trennsteg sichergestellt werden.

Die Erfindung wird anhand der beigefügten Zeichnungen beispielhaft näher erläutert. Es zeigen:
- Fig. 1: eine schematische Darstellung eines Haushaltsgeräts mit einem Infrarotsensor mit einem Sensorsockel gemäß einem Ausführungsbeispiel der vorliegenden Erfindung;
- Fig. 2: eine perspektivische Darstellung eines Sensorsockels gemäß einem Ausführungsbeispiel der vorliegenden Erfindung;
- Fig. 3: eine perspektivische Darstellung eines Sensorsockels gemäß einem Ausführungsbeispiel der vorliegenden Erfindung;
- Fig. 4: eine schematische Darstellung eines Infrarotsensors mit einem Sensorsockel gemäß einem Ausführungsbeispiel der vorliegenden Erfindung;
- Fig. 5: eine schematische Darstellung eines Infrarotsensors mit einem Sensorsockel gemäß einem Ausführungsbeispiel der vorliegenden Erfindung;
- Fig. 6: eine perspektivische Darstellung eines Sensorsockels gemäß einem Ausführungsbeispiel der vorliegenden Erfindung;
- Fig. 7: eine perspektivische Darstellung eines Sensorsockels gemäß einem Ausführungsbeispiel der vorliegenden Erfindung
- Fig. 8: eine schematische Darstellung eines Infrarotsensors mit einem Sensorsockel gemäß einem Ausführungsbeispiel der vorliegenden Erfindung; und
- Fig. 9: eine schematische Darstellung eines Infrarotsensors mit einem Sensorsockel gemäß einem Ausführungsbeispiel der vorliegenden Erfindung.

In der nachfolgenden Beschreibung bevorzugter Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

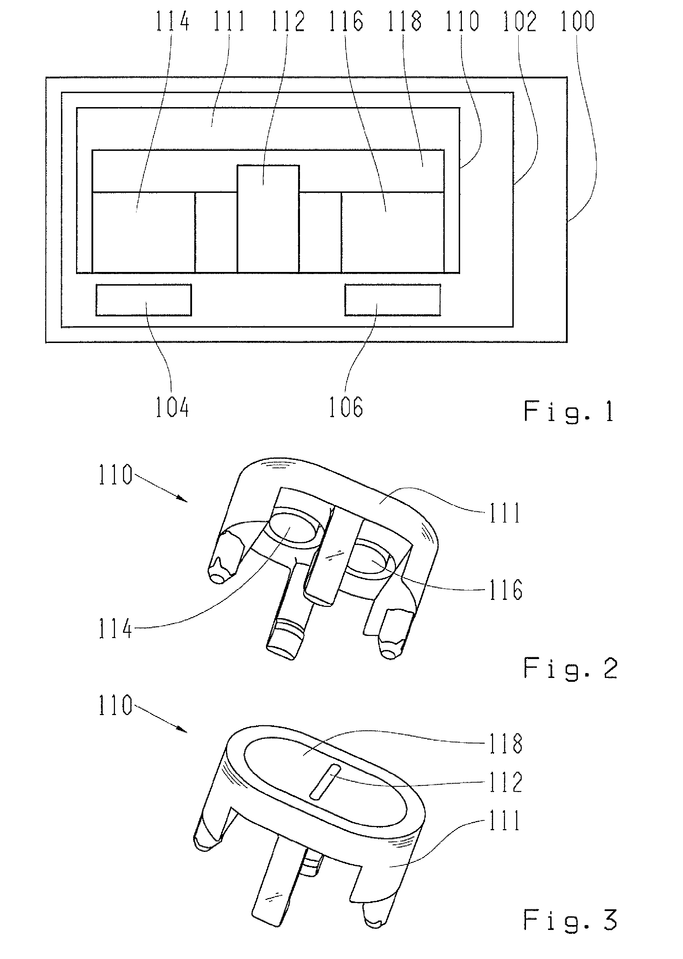

Fig. 1 zeigt eine schematische Darstellung eines Haushaltsgeräts mit einem Infrarotsensor mit einem Sensorsockel gemäß einem Ausführungsbeispiel der vorliegenden Erfindung. Gezeigt sind ein Haushaltsgerät 100, ein Infrarotsensor 102, ein Sender 104 für Infrarotstrahlung, ein Empfänger 106 für Infrarotstrahlung, ein Sensorsockel 110, ein Sockelkörper 111, ein Trennsteg 112, ein Sendelichtleiter 114, ein Empfangslichtleiter 116 und ein Verbindungselement 118. Das Haushaltsgerät 100, das beispielsweise ein Herd oder ein Kochfeld sein kann, weist den Infrarotsensor 102 auf. Der Infrarotsensor 102 weist den Sender 104, den Empfänger 106 und den Sensorsockel 110 auf. Auch wenn es in Fig. 1 nicht gezeigt ist, kann der Infrarotsensor 102 auch weitere Elemente aufweisen, beispielsweise eine Elektronikeinheit oder dergleichen. Der Sensorsockel 110 weist den Sockelkörper 111, wobei der Trennsteg 112 einen Teil des Sockelkörpers 111 repräsentiert, und eine einstückig ausgebildete Lichtleiteinrichtung auf, welche den Sendelichtleiter 114, den Empfangslichtleiter 116 und das Verbindungselement 118 aufweist.

Bei dem Haushaltsgerät 100 kann es sich beispielsweise um ein Kochfeld handeln, das eine Glasplatte mit einer ersten Hauptoberfläche zum Abstellen von Kochgut und einer zweiten Hauptoberfläche mit einer Noppenstruktur aufweist. Das Kochfeld kann ein Bedienfeld aufweisen, das in einem Abschnitt der Glasplatte angeordnet ist. Dabei kann eine Bedienung des Kochfeldes mittels des Bedienfeldes sowie des Infrarotsensors 102 bzw. eines berührungsempfindlichen Tastschalters durch die Glasplatte hindurch erfolgen. Der Infrarotsensor 102 kann Teil des berührungsempfindlichen Tastschalters sein bzw. demselben funktionell zugeordnet und mit demselben verbunden sein. Der Infrarotsensor 102, und insbesondere der Sensorsockel 110 bzw. das Verbindungselement 118 des Sensorsockels 110, kann benachbart zu der zweiten Hauptoberfläche der Glasplatte des Kochfeldes bzw. Haushaltsgerätes 100 angeordnet sein.

Der Sockelkörper 111 des Sensorsockels 110, der auch den Trennsteg 112 umfasst, ist aus einem zumindest für elektromagnetische Strahlung im Infrarotbereich undurchlässigen Material hergestellt. Der Sockelkörper 111 des Sensorsockels 110 ist ausgebildet, um die Lichtleiteinrichtung, die einstückig aus dem Sendelichtleiter 114, dem Empfangslichtleiter 116 und dem Verbindungselement 118 gebildet ist, aufzunehmen, wobei zwischen dem Sockelkörper 111 und zumindest Teilen der Lichtleiteinrichtung ein Luftspalt verbleibt, damit die Lichtleiteinrichtung die elektromagnetische Strahlung leiten kann. Der Trennsteg 112 ist ausgebildet, um eine optische Trennung zwischen gesendeter elektromagnetischer Strahlung und empfangener elektromagnetischer Strahlung innerhalb der Lichtleiteinrichtung zu bewirken.

Die Lichtleiteinrichtung ist ausgebildet, um zumindest elektromagnetische Strahlung im Infrarotbereich zu leiten. Das Verbindungselement 118 der Lichtleiteinrichtung ist gemäß dem in Fig. 1 dargestellten Ausführungsbeispiel der vorliegenden Erfindung beispielhaft scheibenförmig oder plattenförmig ausgebildet. Das Verbindungselement 118 ist aus einem optisch leitfähigen Material gebildet. Unter einem optisch leitfähigen Material wird in dieser Offenbarung auch ein Material verstanden, welches für elektromagnetische Strahlung im infraroten Spektralbereich durchlässig ist. Das Verbindungselement 118 weist eine erste Hauptoberfläche und eine zweite Hauptoberfläche auf.

An der ersten Hauptoberfläche des Verbindungselements 118 sind der Sendelichtleiter 114 und der Empfangslichtleiter 116 angeordnet. Die erste Hauptoberfläche des Verbindungselements 118 weist eine Ausnehmung auf, die der Trennsteg 112 hineinragt. Die Ausnehmung ist zwischen dem Sendelichtleiter 114 und dem Empfangslichtleiter 116 gebildet. Die Ausnehmung weist gemäß dem in Fig. 1 gezeigten Ausführungsbeispiel der vorliegenden Erfindung bezüglich der ersten Hauptoberfläche des Verbindungselements 118 eine Tiefe auf, die beispielhaft geringer als eine Dicke des Verbindungselements 118 ist. Alternativ könnte die Ausnehmung auch als eine Durchgangsöffnung in dem Verbindungselement 118 ausgebildet sein, wobei sich der Trennsteg 112 hierbei durch das Verbindungselement 118 hindurch erstrecken könnte.

Die zweite Hauptoberfläche des Verbindungselements 118 kann benachbart zu der die Noppenstruktur aufweisenden, zweiten Hauptoberfläche der Glasplatte des Kochfeldes bzw. des Haushaltsgeräts 100 angeordnet sein. Die zweite Hauptoberfläche des Verbindungselements 118 kann zumindest einen Lichtstreuungsabschnitt aufweisen, auch wenn derselbe in Fig. 1 nicht dargestellt ist. Der zumindest eine Lichtstreuungsabschnitt kann sich hierbei zumindest teilweise über die zweite Hauptoberfläche des Verbindungselements 118 erstrecken.

Der Sendelichtleiter 114 und der Empfangslichtleiter 116 sind zylindrisch ausgebildet. Der Sendelichtleiter 114 und der Empfangslichtleiter 116 erstrecken sich von der ersten Hauptoberfläche des Verbindungselements 118 aus innerhalb von Fertigungstoleranzen in die gleiche Richtung. Ein von dem Verbindungselement 118 abgewandtes, freies Ende des Sendelichtleiters 114 ist benachbart zu dem Sender 104 angeordnet. Ein von dem Verbindungselement 118 abgewandtes, freies Ende des Empfangslichtleiters 116 ist benachbart zu dem Empfänger 106 angeordnet.

Der Sender 104 ist ausgebildet, um elektromagnetische Strahlung im Infrarotbereich bzw. Infrarotlicht zu emittieren. Das von dem Sender 104 emittierte Infrarotlicht tritt in das freie Ende des Sendelichtleiters 114 ein. Der Sendelichtleiter 114 ist ausgebildet, um das Infrarotlicht zu dem Verbindungselement 118 zu leiten. Das Infrarotlicht durchläuft dann das Verbindungselement 118 von dessen erster Hauptoberfläche zu dessen zweiter Hauptoberfläche. Die zweite Hauptoberfläche des Verbindungselements 118 bzw. der in Fig. 1 nicht dargestellte Lichtstreuungsabschnitt im Bereich des Sendelichtleiters 114 ist ausgebildet, um das Infrarotlicht in gestreuter Weise von dem Sensorsockel 110 weg abzustrahlen. Das ausgesendete Infrarotlicht kann dann auf das Bedienfeld des Haushaltsgeräts 100 auftreffen, wo es beispielsweise von einem Finger einer Bedienperson des Haushaltsgeräts 100 und gegebenenfalls von der Noppenstruktur der zweiten Hauptoberfläche der Glasplatte des Haushaltsgeräts 100 reflektiert werden kann. Reflektiertes Infrarotlicht trifft dann auf die zweite Hauptoberfläche des Verbindungselements 118 auf. Im Bereich des Empfangslichtleiters 116 durchläuft das empfangene, reflektierte Infrarotlicht das Verbindungselement 118 zu dem Empfangslichtleiter 116 hin. Der Empfangslichtleiter 116 ist ausgebildet, um das Infrarotlicht von dem Verbindungselement 118 zu dem freien Ende des Empfangslichtleiters 116 zu leiten. An dem freien Ende des Empfangslichtleiters 116 tritt das Infrarotlicht aus dem Empfangslichtleiter 116 aus. Der Empfänger 106 ist ausgebildet, um das Infrarotlicht zu empfangen.

Fig. 2 zeigt eine perspektivische Darstellung eines Sensorsockels 110 gemäß einem Ausführungsbeispiel der vorliegenden Erfindung. Bei dem Sensorsockel 110 kann es sich um den Sensorsockel aus Fig. 1 handeln. Gezeigt sind der Sockelkörper 111, der Sendelichtleiter 114 und der Empfangslichtleiter 116. Der Sockelkörper 111 weist einen Hauptabschnitt auf, in dem der Sendelichtleiter 114 und der Empfangslichtleiter 116 aufgenommen sind. In der Ansicht von Fig. 2 sind von dem Sockelkörper 111 auch Vorsprünge zur Befestigung des Sockelkörpers 111 an einem Infrarotsensor bzw. einer Trägerstruktur dargestellt. Die Vorsprünge erstrecken sich von dem Hauptabschnitt des Sockelkörpers 111 in die gleiche Richtung wie der Sendelichtleiter 114 und der Empfangslichtleiter 116, jedoch über die freien Enden der Lichtleiter hinaus. In Fig. 2 sind beispielhaft vier Vorsprünge gezeigt.

Fig. 3 zeigt eine perspektivische Darstellung eines Sensorsockels 110 gemäß einem Ausführungsbeispiel der vorliegenden Erfindung. Bei dem Sensorsockel 110 kann es sich um den Sensorsockel aus Fig. 2 handeln. Fig. 3 kann den Sensorsockel 110 aus einer anderen Perspektive als Fig. 2 darstellen. Gezeigt sind der Sockelkörper 111, der Trennsteg 112 und das Verbindungselement 118. Von den in Fig. 2 gezeigten Vorsprüngen des Sockelkörpers 111 sind in Fig. 3 aufgrund der Perspektive lediglich drei dargestellt. Das Verbindungselement 118 ist in dem Hauptabschnitt des Sockelkörpers 111 aufgenommen. Die zweite Hauptoberfläche des Verbindungselements 118 ist dabei freiliegend. Ein Umriss einer Grundfläche des Verbindungselements 118 weist beispielhaft eine ovale Form aus Kreisbögen und Geraden auf. Die ovale Form ist hierbei symmetrisch mit einer kurzen Symmetrieachse und einer langen Symmetrieachse. Der Trennsteg 112 erstreckt sich entlang der kurzen Symmetrieachse der Grundfläche des Verbindungselements 118. Dabei erstreckt sich der Trennsteg 112 in Fig. 3 nicht entlang der gesamten Länge der kurzen Symmetrieachse der Grundfläche des Verbindungselements 118.

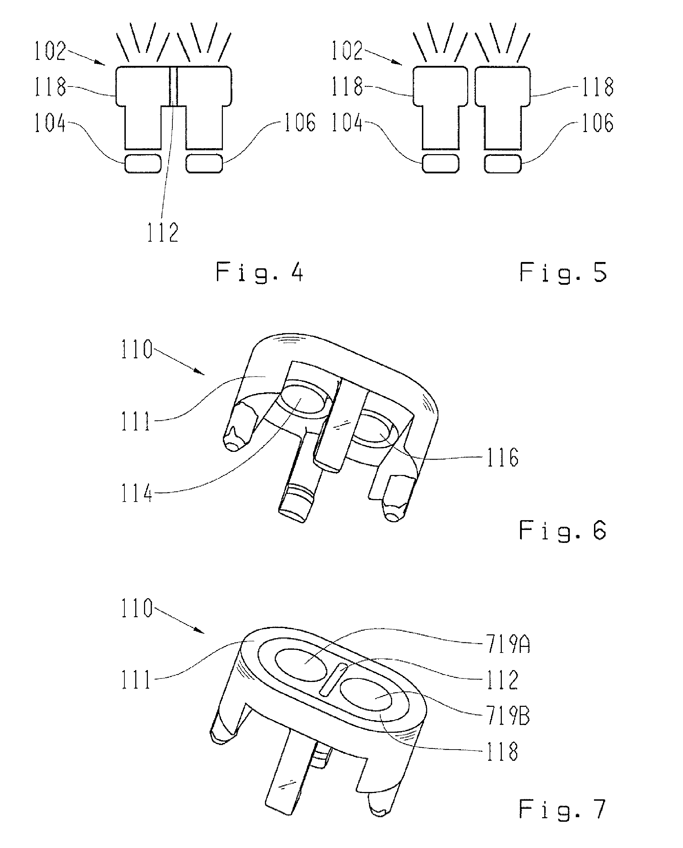

Fig. 4 zeigt eine schematische Darstellung eines Infrarotsensors mit einem Sensorsockel gemäß einem Ausführungsbeispiel der vorliegenden Erfindung. Bei dem Infrarotsensor kann es sich um den Infrarotsensor aus Fig. 1 handeln. Bei dem Sensorsockel kann es sich um den Sensorsockel aus einer der Figuren 1 bis 3 handeln. Gezeigt sind der Infrarotsensor 102, der Sender 104, der Empfänger 106 und der Sensorsockel 110 mit dem Trennsteg 112.

Fig. 5 zeigt eine schematische Darstellung eines Infrarotsensors mit einem Sensorsockel gemäß einem Ausführungsbeispiel der vorliegenden Erfindung. Bei dem Infrarotsensor kann es sich um den Infrarotsensor aus Fig. 1 handeln. Bei dem Sensorsockel kann es sich um den Sensorsockel aus einer der Figuren 1 bis 3 handeln. Gezeigt sind der Infrarotsensor 102, der Sender 104, der Empfänger 106 und der Sensorsockel 110. Die Darstellung in Fig. 5 entspricht der Darstellung aus Fig. 4 mit der Ausnahme, dass der Trennsteg des Sensorsockels 110 nicht explizit gezeigt ist. Der Trennsteg ist hierbei mittels einer Lücke bzw. eines Spaltes in dem Sockelkörper des Sensorsockels 110 realisiert. Dabei kann die Lücke oder der Spalt innerhalb an den Rändern durch Brücken überbrückst sein, so dass die einstückige Form des Verbindungselementes wieder realisiert werden kann.

Fig. 6 zeigt eine perspektivische Darstellung eines Sensorsockels 110 gemäß einem Ausführungsbeispiel der vorliegenden Erfindung. Bei dem Sensorsockel 110 kann es sich um den Sensorsockel aus einer der Figuren 1 bis 5 handeln. Gezeigt sind ebenfalls der Sockelkörper 111, der Sendelichtleiter 114 und der Empfangslichtleiter 116. Die Darstellung in Fig. 6 entspricht der Darstellung aus Fig. 2 bis auf die Tatsache, dass Fig. 6 den Sensorsockel 110 aus einer etwas anderen Perspektive als Fig. 2 zeigen kann.

Fig. 7 zeigt eine perspektivische Darstellung eines Sensorsockels 110 gemäß einem Ausführungsbeispiel der vorliegenden Erfindung. Bei dem Sensorsockel 110 kann es sich um den Sensorsockel aus einer der Figuren 1 bis 6 handeln. Die Darstellung in Fig. 7 entspricht der Darstellung aus Fig. 3 mit der Ausnahme, dass in Fig. 7 zusätzlich zu dem Sockelkörper 111, dem Trennsteg 112 und dem Verbindungselement 118 ein Lichtstreuungsabschnitt 719A und ein weiterer Lichtstreuungsabschnitt 719B gezeigt sind. Der Lichtstreuungsabschnitt 719A und der weitere Lichtstreuungsabschnitt 719B sind in dem Verbindungselement 118 gebildet. Genau gesagt sind der Lichtstreuungsabschnitt 719A und der weitere Lichtstreuungsabschnitt 719B an der zweiten Hauptoberfläche des Verbindungselements 118 gebildet. Dabei können sich der Lichtstreuungsabschnitt 719A und der weitere Lichtstreuungsabschnitt 719B von der zweiten Hauptoberfläche des Verbindungselements 118 ausgehend in das Verbindungselement hinein erstrecken, auch wenn dies in Fig. 7 nicht explizit gezeigt ist. Der Lichtstreuungsabschnitt 719A ist gemäß dem in Fig. 7 gezeigten Ausführungsbeispiel der vorliegenden Erfindung als eine linsenartige Struktur ausgebildet. Der Lichtstreuungsabschnitt 719A kann beispielsweise im Bereich des Sendelichtleiters des Sensorsockels 110 angeordnet sein. Der weitere Lichtstreuungsabschnitt 719B ist gemäß dem in Fig. 7 gezeigten Ausführungsbeispiel der vorliegenden Erfindung als eine linsenartige Struktur ausgebildet. Der weitere Lichtstreuungsabschnitt 719B kann beispielsweise im Bereich des Empfangslichtleiters des Sensorsockels 110 angeordnet sein.

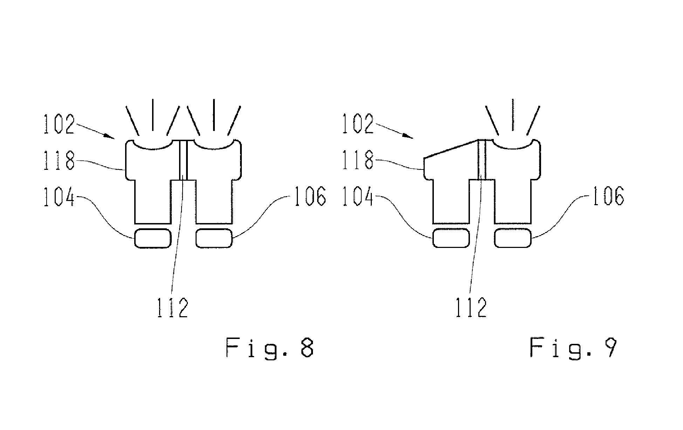

Fig. 8 zeigt eine schematische Darstellung eines Infrarotsensors mit einem Sensorsockel gemäß einem Ausführungsbeispiel der vorliegenden Erfindung. Bei dem Infrarotsensor kann es sich um den Infrarotsensor aus Fig. 1 handeln. Bei dem Sensorsockel kann es sich um den Sensorsockel aus Fig. 7 handeln. Gezeigt sind der Infrarotsensor 102, der Sender 104, der Empfänger 106 und der Sensorsockel 110 mit dem Trennsteg 112. Die Darstellung in Fig. 8 entspricht der Darstellung aus Fig. 4 mit der Ausnahme, dass die in Fig. 7 gezeigten Lichtstreuungsabschnitte in Fig. 8 als gekrümmte Vertiefungen in dem Sensorsockel 110 dargestellt sind. Auch wenn es in Fig. 8 nicht explizit gezeigt ist, sind die gekrümmte Vertiefungen, welche die Lichtstreuungsabschnitte repräsentieren, an der zweiten Hauptoberfläche des Verbindungselements der Lichtleiteinrichtung des Sensorsockels 110 gebildet.

Fig. 9 zeigt eine schematische Darstellung eines Infrarotsensors mit einem Sensorsockel gemäß einem Ausführungsbeispiel der vorliegenden Erfindung. Bei dem Infrarotsensor kann es sich um den Infrarotsensor aus Fig. 1 handeln. Gezeigt sind der Infrarotsensor 102, der Sender 104, der Empfänger 106 und der Sensorsockel 110 mit dem Trennsteg 112. Die Darstellung in Fig. 9 entspricht weitgehend der Darstellung aus Fig. 8. Bei dem Sensorsockel 110 kann es sich um den Sensorsockel aus Fig. 7 oder Fig. 8 handeln, mit der Ausnahme, dass der auf der Seite des Senders 104 angeordnete Lichtstreuungsabschnitt in Gestalt eines geneigten Abschnitts des Sensorsockels 100 realisiert ist. Auch wenn es in Fig. 9 nicht explizit gezeigt ist, ist der geneigte Abschnitt in der zweiten Hauptoberfläche des Verbindungselements der Lichtleiteinrichtung des Sensorsockels 110 gebildet. Hierbei erstreckt sich der geneigte Abschnitt beispielhaft von dem Trennsteg 112 bis zu einem Rand des Sensorsockels 100. Der auf der Seite des Empfängers 106 angeordnete Lichtstreuungsabschnitt entspricht dem in Fig. 8 dargestellten.

Unter Bezugnahme auf die Figuren 1 bis 9 werden im Folgenden Sensorsockel und Infrarotsensoren mit Sensorsockeln gemäß Ausführungsbeispielen der vorliegenden Erfindung mit anderen Worten nochmals zusammenfassend erläutert.

Die bei Kochfeldsteuerungen verwendete Glasplatte hat auf der Unterseite eine Art Noppenstruktur. Diese Noppen entsprechen von der Struktur her einzelnen Linsen, sodass die Glasplatte auf der Unterseite keine homogene Oberfläche aufweist. Mittels des Sensorsockels 110 gemäß Ausführungsbeispielen der vorliegenden Erfindung kann verhindert werden, dass bei kleinen Bewegungen des Glases oder Verschiebungen des Glases der Infrarotsensor 102 derart beeinflusst wird, dass sich der Infrarotsensor 102 selbstständig betätigt. Bei diesen sicherheitskritischen Punkt kann bei einer Verschiebung der Glasplatte beispielsweise durch Anrempeln, kleinen Erdbewegungen, etc. vermieden werden, dass der reflektierte Lichtstrahl z. B. nicht mehr vom Empfänger 106 erfasst wird bzw. der Lichtstrahl reflektiert wird, ohne dass ein Betätiger den Lichtstrahl reflektiert. Mittels des Sensorsockels 110 gemäß Ausführungsbeispielen der vorliegenden Erfindung können unterschiedliche Transmissionseigenschaften unterschiedlicher Noppengeometrien verschiedener Glasflächen und die damit verbundenen unterschiedliche Beeinflussung des Infrarotsensors 102 kompensiert werden und können die Schalteigenschaften des Infrarotsensors 102 somit positiv beeinflusst werden. Es braucht somit nicht für jeden Glastyp ein eigenes Programm für die Ansteuerung bzw. die Auswertung seitens des Infrarotsensors 102 erstellt werden. Es kann also vermieden werden, dass die Noppenstruktur der Glasplatte einen negativen Einfluss auf das Schaltverhalten des Infrarotsensors 102 hat.

Die verwendete Lichtleiteinrichtung des Sensorsockels 110 ist ausgebildet, um Licht vom Sender zum Empfänger zu transportieren. Die Besonderheit hierbei ist, dass die zweite Hauptoberfläche des Verbindungselements 118 mit dem Lichtstreuungsabschnitt bzw. einer Struktur zur Lichtstreuung versehen wird. Bei den Lichtleitern kann es sich um eine Lichtleiteinrichtung handeln, die so aufgebaut ist, dass beide Lichtleiter 114 und 116 bzw. Zylinder in der Lichtleiteinrichtung gemeinsam integriert sind. Um dann eine Fehlleitung zu verhindern, z. B. ein direktes Abstrahlen von dem Sendelichtleiter 114 auf den Empfangslichtleiter 116, wird zwischen den Sendelichtleiter 114 und dem Empfangslichtleiter 116 der Trennsteg 112 vorgesehen. Die zweite Hauptoberfläche des Verbindungselements 118 wird dann oder ist bereits mit dem Lichtstreuungsabschnitt bzw. einer Struktur versehen, welche dazu führt, dass das Licht beim Austreten aus der Lichtleiteinrichtung gestreut wird. Mittels des Lichtstreuungsabschnitts wird dann erreicht, dass das über die gesamte Oberfläche verteilte Licht auf der Empfängerseite auftrifft, um eine möglichst homogene Empfängerfläche zu schaffen. Durch die strukturierte, beispielsweise raue, Oberfläche wird eine Streuung erzeugt, welche den Einfluss der Noppen auf der Glasplatte reduziert bzw. kompensiert. Das austretende Licht wird gestreut und trifft über die gesamte oberhalb des Empfangslichtleiters 114 gelegene Fläche des Verbindungselements 118 der Lichtstrahl möglichst homogen verteilt wieder auf, um vom Empfänger 106 detektiert zu werden.

Da der Lichtstrahl breit gefächert ist, hat eine Noppenstruktur auf der Oberfläche der Glasplatte keinen Einfluss mehr, denn selbst wenn ein Teil des Lichtstrahls umgelenkt wird und nicht mehr den Empfänger 106 trifft, wird ein anderer Teil des Lichtstrahls sicher zu dem Empfänger 106 reflektiert bzw. wird nur ein kleiner Teil des gesamten Lichtstrahls abgelenkt und es kommt nicht zu einem versehentliehen betätigen des Infrarotsensors 102. Die strukturierte Oberfläche im Bereich des Lichtstreuungsabschnitts kann auf verschiedene Arten erzeugt werden. Entweder kann die Oberflächenstruktur direkt beim Spritzen der Lichtleiteinrichtung mit erzeugt werden oder es kann eine strukturierte Folie auf der Lichtleiteinrichtung aufgebracht werden oder aber es kann mittels eines Laser die Struktur nicht nur oberflächlich sondern auch im Inneren der Lichtleiteinrichtung erzeugt werden. Anstelle einer strukturierten Oberfläche kann auch eine Art Linse 719A, 719B gebildet werden. Die Vorteile der Linse 719A, 719B entsprechen denen der strukturierten Oberfläche des Lichtstreuungsabschnitts.

Ebenfalls denkbar wäre noch eine Alternative, die vorsieht beispielsweise lediglich auf der Seite des Empfängers 106 die Linsenstruktur 719B vorzusehen und auf der anderen Seite eine Schräge zur Streuung des Lichtstrahls zu verwenden.

Gemäß Ausführungsbeispielen der vorliegenden Erfindung kann somit ein optimierter Sensorsockel 110 bzw. Lichtleitsockel für einen Infrarotsensor 102 geschaffen werden. Durch die vorteilhafte Streuung des Lichts mittels des Sensorsockels 110 wird der Infrarotsensor 102 unempfindlicher gegenüber Störlicht und Fehlreflexionen. Dabei wird statt einer punktuellen Ausbreitung des Lichts eine Streuung des Lichts bzw. Verteilung des Lichtstrahls über eine größere Fläche bewirkt. Der Einfluss der Noppenstruktur auf den Infrarotsensor 102 kann somit reduziert oder beseitigt werden. Ferner wird aufgrund der einstückigen Ausformung der Lichtleiteinrichtung ein einfacher Einbau der Lichtleiteinrichtung in den Sensorsockel 110 ermöglicht.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden.

### Bezugszeichen

- 100: Haushaltsgerät
- 102: Infrarotsensor
- 104: Sender
- 106: Empfänger
- 110: Sensorsockel
- 111: Sockelkörper
- 112: Trennsteg
- 114: Sendelichtleiter
- 116: Empfangslichtleiter
- 118: Verbindungselement
- 719A: Lichtstreuungsabschnitt
- 719B: weiterer Lichtstreuungsabschnitt

## Patentansprüche

1. Sensorsockel (110) für einen Infrarotsensor (102) eines Tastschalters, wobei der Sensorsockel (110) einen Senderabschnitt sowie einen Empfängerabschnitt und eine Lichtleiteinrichtung aufweist, **dadurch gekennzeichnet, dass** die Lichtleiteinrichtung ein Verbindungselement (118) und einen einstückig mit dem Verbindungselement (118) gebildeten, ersten Lichtleiter (114) sowie einen einstückig mit dem Verbindungselement (118) gebildeten, zweiten Lichtleiter (116) aufweist, wobei der erste Lichtleiter (114) in dem Senderabschnitt angeordnet ist und der zweite Lichtleiter (116) in dem Empfängerabschnitt angeordnet ist, wobei sich der erste Lichtleiter (114) und der zweite Lichtleiter (116) von einer ersten Hauptoberfläche des Verbindungselements (118) in eine gemeinsame Richtung weg erstrecken.

2. Sensorsockel (110) gemäß Anspruch 1, **dadurch gekennzeichnet, dass** das Verbindungselement (118) der Lichtleiteinrichtung einen Lichtstreuungsabschnitt aufweist, der zumindest im Bereich des Senderabschnitts des Sensorsockels (110) an einer von der ersten Hauptoberfläche abgewandten, zweiten Hauptoberfläche des Verbindungselements (118) angeordnet ist.

3. Sensorsockel (110) gemäß Anspruch 2, **dadurch gekennzeichnet, dass** der Lichtstreuungsabschnitt einen strukturierten Abschnitt der zweiten Hauptoberfläche des Verbindungselements (118) aufweist.

4. Sensorsockel (110) gemäß Anspruch 3, **dadurch gekennzeichnet, dass** sich der strukturierte Abschnitt von der zweiten Hauptoberfläche zumindest teilweise in das Verbindungselement (118) der Lichtleiteinrichtung erstreckt.

5. Sensorsockel (110) gemäß einem der Ansprüche 2 bis 4, **dadurch gekennzeichnet, dass** der Lichtstreuungsabschnitt einen Abschnitt aufweist, der bezüglich einem weiteren Abschnitt des zweiten Hauptoberfläche des Verbindungselements (118) geneigt ist.

6. Sensorsockel (110) gemäß einem der Ansprüche 2 bis 5, **dadurch gekennzeichnet, dass** der Lichtstreuungsabschnitt eine an der zweiten Hauptoberfläche des Verbindungselements (118) aufgebrachte, strukturierte Schicht aufweist.

7. Sensorsockel (110) gemäß einem der Ansprüche 2 bis 6, **dadurch gekennzeichnet, dass** das Verbindungselement (118) der Lichtleiteinrichtung einen weiteren Lichtstreuungsabschnitt aufweist, der zumindest im Bereich des Empfängerabschnitts des Sensorsockels (110) an der zweiten Hauptoberfläche des Verbindungselements (118) angeordnet ist.

8. Sensorsockel (110) gemäß einem der vorangegangenen Ansprüche, **dadurch gekennzeichnet, dass** der Sensorsockel (110) einen Trennsteg (112) zwischen dem Senderabschnitt und dem Empfängerabschnitt aufweist, der ausgebildet ist, um eine optische Trennung der Lichtleiteinrichtung zwischen dem Senderabschnitt und dem Empfängerabschnitt zu bewirken.

9. Sensorsockel (110) gemäß Anspruch 8, **dadurch gekennzeichnet, dass** sich der Trennsteg (112) zumindest teilweise bis zu einer von der ersten Hauptoberfläche abgewandten, zweiten Hauptoberfläche des Verbindungselements (118) der Lichtleiteinrichtung erstreckt.

10. Sensorsockel (110) gemäß einem der Ansprüche 8 oder 9, **dadurch gekennzeichnet, dass** das Verbindungselement (118) eine Ausnehmung oder Öffnung für den Trennsteg (112) aufweist, die sich von der ersten Hauptoberfläche zumindest teilweise bis zu der zweiten Hauptoberfläche erstreckt.

11. Steuergerät, insbesondere für ein Haushaltsgerät (100) mit einem zumindest teilweise lichtdurchlässigen Bedienfeld, wobei das Steuergerät einen berührungsempfindlichen Tastschalter mit einem Infrarotsensor (102) aufweist, **dadurch gekennzeichnet, dass** der Infrarotsensor (102) einen Sensorsockel (110) gemäß einem der vorangegangenen Ansprüche aufweist, wobei das Verbindungselement (118) der Lichtleiteinrichtung des Sensorsockels (110) benachbart zu dem Bedienfeld des Haushaltsgeräts (100) anordenbar ist.
